# EUROPÄISCHE PATENTSCHRIFT

(11) **EP 3 997 764 B1**
(45) Veröffentlichungstag und Bekanntmachung des Hinweises auf die Patenterteilung: **14.01.2026**
(21) Anmeldenummer: 20733301.4
(22) Anmeldetag: 22.06.2020
(51) Int. Cl.: H01R 13/66, B60L 53/16, B60L 53/30, B60L 53/60, H01R 13/713

(54) **ELEKTRISCHE BAUGRUPPE MIT EINER TEMPERATURÜBERWACHUNGSEINRICHTUNG**
ELECTRIC ASSEMBLY WITH A TEMPERATURE MONITORING DEVICE
SOUS-ENSEMBLE ÉLECTRIQUE COMPORTANT UN DISPOSITIF DE SURVEILLANCE DE LA TEMPÉRATURE

(30) Priorität: 11.07.2019 LU 101309
(43) Veröffentlichungstag der Anmeldung: 18.05.2022
(73) Patentinhaber: Phoenix Contact e-Mobility GmbH, 32816 Schieder-Schwalenberg (DE)
(72) Erfinder: FÜHRER, Thomas, 32825 Blomberg (DE)
(74) Vertreter: Meyer-Graefe, Karsten
(86) Internationale Anmeldenummer: PCT/EP2020/067280
(87) Internationale Veröffentlichungsnummer: WO 2021/004765

(56) Entgegenhaltungen:
- WO-A1-2018/197247
- DE-A1- 102014 111 334
- DE-A1- 102015 106 251
- DE-A1- 102016 107 401
- DE-A1- 102018 120 057
- DE-U1- 202017 105 818

## Beschreibung

Die Erfindung betrifft eine elektrische Baugruppe nach dem Oberbegriff des Anspruchs 1 und ein Steckverbinderteil zum steckenden Verbinden mit einem Gegensteckverbinderteil.

Eine solche elektrische Baugruppe umfasst ein Trägerelement, das einen Körper und eine an dem Körper gebildete Oberfläche aufweist. Die elektrische Baugruppe umfasst zudem ein an dem Trägerelement angeordnetes, elektrisches Funktionselement und eine an dem Trägerelement angeordnete Temperaturüberwachungseinrichtung zum Überwachen einer Temperatur an dem elektrischen Funktionselement. Die Temperaturüberwachungseinrichtung weist einen an der Oberfläche des Trägerelements angeordneten Temperatursensor, ein an der Oberfläche des Trägerelements angeordnetes Anlageelement und zumindest eine in dem Körper des Trägerelements eingebettete Wärmeleiteinrichtung auf, wobei die zumindest eine Wärmeleiteinrichtung sich zumindest abschnittsweise unterhalb des Temperatursensors in dem Körper erstreckt und thermisch über zumindest eine Durchkontaktierung mit dem Anlageelement verbunden ist und wobei das Anlageelement in thermischer Kopplung mit einer mit dem elektrischen Funktionselement wirkverbundenen Kopplungsfläche ist.

Eine solche elektrische Baugruppe kann beispielsweise Bestandteil eines Steckverbinderteils sein, bei dem es sich zum Beispiel um einen Stecker oder eine Buchse handeln kann. Ein solches Steckverbinderteil kann insbesondere an einer Ladeeinrichtung zum Übertragen eines Ladestroms zum Einsatz kommen. Das Steckverbinderteil kann insbesondere als Ladestecker oder Ladebuchse zum Laden eines elektromotorisch angetriebenen Kraftfahrzeugs (bezeichnet auch als Elektrofahrzeug) ausgebildet sein und kann auf Seiten einer Ladestation, z.B. als Ladestecker an einem Ladekabel, oder auch auf Seiten eines Fahrzeugs als sogenanntes Inlet verwendet werden.

Ladestecker oder Ladebuchsen zum Aufladen von Elektrofahrzeugen sind so auszulegen, dass große Ladeströme übertragen werden können. Weil die thermische Verlustleistung quadratisch mit dem Ladestrom wächst und zudem vorgeschrieben ist, dass eine Temperaturerhöhung an einem Steckverbinderteil 50 K nicht überschreiten darf, ist bei solchen Ladesteckern oder Ladebuchsen erforderlich, eine Temperaturüberwachung bereitzustellen, um eine Überhitzung an Bauteilen des Ladesteckers oder der Ladebuchse frühzeitig zu erkennen und gegebenenfalls eine Modifizierung des Ladestroms oder gar eine Abschaltung der Ladeeinrichtung zu bewirken.

Bei einem aus der EP 2 605 339 A1 bekannten Ladestecker ist ein Temperatursensor an einem Isolierkörper in etwa mittig zwischen Kontaktelementen des Kontaktsteckers angeordnet. Über den Temperatursensor kann erkannt werden, ob irgendwo an den Kontaktelementen es zu einer übermäßigen Erhitzung kommt, um gegebenenfalls ein Abschalten des Ladevorgangs zu bewirken.

Bei einem aus der GB 2 489 988 A bekannten Ladestecker sind mehrere Temperatursensoren vorgesehen, die über eine Leitung Temperaturdaten übermitteln. Abhängig davon, in welchem Temperaturbereich sich die an den Temperatursensoren aufgenommenen Temperaturen befinden, erfolgt eine Regelung eines Ladevorgangs.

Aus der US 6,210,036 B1 ist ein Steckverbinder bekannt, bei dem mehrere Temperatursensoren über eine einadrige Leitung miteinander seriell verkettet sind. Die Temperatursensoren sind an einem Isolierkörper angeordnet und weisen bei einer vorbestimmten Temperatur eine signifikante Widerstandsänderung auf, die so groß ist, dass ein an die Leitung angeschlossener Steuerkreis die Änderung erfassen und den Stromfluss durch den Ladestecker anpassen, gegebenenfalls abschalten kann.

Aus der US 8,325,454 B2 ist ein Stecker bekannt, bei dem einzelnen Kontakten Thermistoren zugeordnet sind, die parallel miteinander verschaltet sind und bei Überschreiten einer Schwelltemperatur einen Thyristor leitend schalten, um auf diese Weise einen Stromfluss durch die Kontakte abzuschalten.

Bei aus dem Stand der Technik bekannten Ladesteckern sind Temperatursensoren zum Beispiel in einen Isolierkörper eingebettet. Dies ist erforderlich, um die Temperatursensoren elektrisch von den Kontaktelementen, an denen es zu einer Erwärmung kommen kann, zu isolieren. Dies bringt aber gleichzeitig den Nachteil mit sich, dass eine Temperaturänderung an einem der Kontaktelemente über den Isolierkörper zeitlich verzögert übertragen wird und somit mit zeitlicher Verzögerung an den Temperatursensoren wahrgenommen wird. Insbesondere bei Konzepten, die eine Schnellabschaltung eines Lastkreises im Fehlerfall ermöglichen sollen, sind derartige Anordnungen von Temperatursensoren daher unter Umständen ungeeignet.

Es besteht ein Bedürfnis nach einer Temperaturüberwachungseinrichtung, die einfach und kostengünstig aufgebaut sein kann und eine Temperaturüberwachung an den Kontaktelementen mit einem schnellen Ansprechverhalten für ein zügiges Einleiten von Gegenmaßnahmen, beispielsweise eine Schnellabschaltung eines Ladestroms, ermöglicht.

Bei einem aus der DE 10 2015 106 251 A1 bekannten Steckverbinderteil sind Kontaktelemente in Öffnungen einer Leiterplatte angeordnet. An der Leiterplatte sind ein oder mehrere Sensoreinrichtungen vorgesehen, die dazu dienen, eine Erwärmung an einem oder mehreren Kontaktelementen zu erfassen.

Bei einem aus der WO 2016/169940 A1 bekannten Steckverbinderteil eines Ladesystems zum Aufladen eines Elektrofahrzeugs ist ein elektrisches Funktionselement in Form eines Kontaktelements an einem Trägerelement in Form einer Leiterplatte angeordnet. Zur thermischen Kopplung mit einem Temperatursensor ist in einen Körper der Leiterplatte ein Kopplungsabschnitt eingebettet, der eine thermische Kopplung zwischen dem Kontaktelement und dem räumlich beabstandet zu dem Kontaktelement angeordneten Temperatursensor herstellt.

Aus der WO 2018/197247 A1 ist ein Steckverbinderteil zum Verbinden mit einem Gegensteckverbinderteil bekannt, welches ein Gehäuseteil, ein an dem Gehäuseteil angeordnetes elektrisches Kontaktelement zum Herstellen eines elektrischen Kontakts mit dem Gegensteckverbinderteil und eine Temperaturüberwachungseinrichtung mit einer Sensoreinrichtung zum Detektieren einer Erwärmung an dem Kontaktelement aufweist. Die Temperaturüberwachungseinrichtung weist ein flächig entlang einer Ebene erstrecktes Trägerelement auf, an dem die Sensoreinrichtung angeordnet ist, das zwei Clipsarme aufweist, über die das Trägerelement auf das Kontaktelement aufgeclipst ist.

Die DE 10 2018 120 057 A1 beschreibt eine Temperaturmesseinrichtung für Steckverbinder, welche mindestens ein Trägerelement, mindestens ein Temperaturmessmittel samt Leiterbahnen sowie bedarfsweise mindestens ein aus Keramikmaterial bestehendes Deckelement aufweist, wobei das Temperaturmessmittel samt Leiterbahnen auf dem Trägerelement oder zwischen dem Trägerelement und dem bedarfsweisen Deckelement aufgebracht ist und zumindest mit einem der beiden Bauteile in Wirkverbindung steht, dergestalt, dass die Verbindung der Bauteile durch ein Glaslot erfolgt.

Weiter beschreibt die DE 20 2017 105 818 U1 ein Steckverbinderteil mit einer an einem Gehäuseteil angeordneten Schnittstelleneinrichtung, die ein Trägerelement mit zumindest einem elektrischen Steckkontakt, an den das zumindest eine Kontaktelement elektrisch kontaktierend ansteckbar ist, und eine an dem Trägerelement angeordnete Anschlusseinrichtung zum Anschließen zumindest einer Leitungsader einer elektrischen Leitung aufweist.

Ein Temperatursensor kann üblicherweise zum Beispiel als oberflächenmontiertes, sogenanntes SMD-Bauteil (SMD: "Surface Mounted Device") auf einem Trägerelement in Form einer Leiterplatte angeordnet sein. Ein solches SMD-Bauteil weist keine Drahtanschlüsse auf und ist mit Kontaktstellen an der Oberfläche des Trägerelements verlötet. Bei einem solchen als SMD-Bauteil ausgeführten Temperatursensor ist dafür Sorge zu tragen, dass der Temperatursensor im Betrieb keine übermäßigen mechanischen Belastungen erfährt, um eine Beeinträchtigung von den Temperatursensor mit dem Trägerelement verbindenden Lötverbindungen zu vermeiden. Dies kann eine thermische Kopplung mit einem zu überwachenden elektrischen Funktionselement aber verkomplizieren.

Zudem hat ein als SMD-Bauteil ausgeführter Temperatursensor üblicherweise eine kleine Bauform und damit eine vergleichsweise geringe Wärmekapazität. Dies kann dazu führen, dass eine von einem elektrischen Funktionselement aufgenommene Erwärmung von dem Temperatursensor unmittelbar in das Trägerelement abgeleitet wird, was das Ansprechverhalten des Temperatursensors verlangsamen kann.

Aufgabe der vorliegenden Erfindung ist es, ein Steckverbinderteil bereitzustellen, das auf einfache und kostengünstige Weise eine Temperaturüberwachung an einen elektrischen Funktionselement, insbesondere einem elektrischen Kontaktelement, mit schnellem Ansprechverhalten und einfachem Aufbau ermöglicht.

Diese Aufgabe wird durch einen Gegenstand mit den Merkmalen des Anspruchs 1 gelöst.

Demnach ist das elektrische Funktionselement mit einem Einsetzelement verbunden und das Trägerelement weist eine Aufnahmeöffnung auf, in die das Einsetzelement eingesetzt ist, wobei das Einsetzelement einen Flanschabschnitt aufweist, an dem die Kopplungsfläche angeordnet ist, wobei das Einsetzelement eine Öffnung aufweist, in die das elektrische Funktionselement eingesetzt ist, und wobei an der Kopplungsfläche eine Aufnahmekammer geformt ist, in der der Temperatursensor der Temperaturüberwachungseinrichtung aufgenommen ist.

Die Wärmeleiteinrichtung kann beispielsweise flächig entlang einer Ebene des Trägerelements, das beispielsweise durch eine Leiterplatte ausgebildet ist, erstreckt sein, wobei mehrere Wärmeleiteinrichtungen parallel zueinander in unterschiedlichen Ebenen des Trägerelements angeordnet sein können. Die Wärmeleiteinrichtung kann beispielsweise eine Scheibenform, beispielsweise eine Kreisscheibenform aufweisen. Alternativ kann die Wärmeleiteinrichtung beispielsweise durch eine Struktur von wärmeleitenden Bahnen, beispielsweise in Form eines Gitters gebildet sein.

Bei der elektrischen Baugruppe wird eine thermische Kopplung zwischen dem elektrischen Funktionselement, beispielsweise einem elektrischen Kontaktelement eines Steckverbinderteils, und der Temperaturüberwachungseinrichtung über ein Anlageelement hergestellt, dass bei montierter elektrischer Baugruppe in thermisch koppelnder Anlage mit einer zugeordneten Kopplungsfläche des elektrischen Funktionselements ist. Das Anlageelement befindet sich vorzugsweise in unmittelbarer räumlicher Nähe zu dem Temperatursensor der Temperaturüberwachungseinrichtung und erstreckt sich beispielsweise, in einer Ausgestaltung, kreisbogenförmig um den Temperatursensor herum. Über das Anlageelement kann thermische Energie von dem elektrischen Funktionselement in die Temperaturüberwachungseinrichtung eingeleitet werden, um mittels des Temperatursensors eine Erwärmung an dem elektrischen Funktionselement zu überwachen.

Das Anlageelement ist thermisch mit einer oder mehreren in dem Körper des Trägerelements eingebetteten Wärmeleiteinrichtungen verbunden. Die thermische Verbindung wird hierbei über eine oder mehrere Durchkontaktierungen hergestellt, sodass Wärme von dem Anlageelement über die eine oder die mehreren Durchkontaktierungen hin zu der oder den in dem Körper des Trägerelements eingebetteten Wärmeleiteinrichtungen geleitet werden kann.

Vorzugsweise ist die zumindest eine Wärmeleiteinrichtung unterhalb des Anlageelements in dem Körper des Trägerelements eingebettet. Über eine oder mehrere Durchkontaktierungen wird eine Verbindung zwischen dem Anlageelement und der oder den darunter angeordneten Wärmeleiteinrichtungen hergestellt, sodass Wärme von dem Anlageelement in die Wärmeleiteinrichtungen eingeleitet werden kann.

Die zumindest eine Wärmeleiteinrichtung erstreckt sich zumindest abschnittsweise unterhalb des Temperatursensors in dem Körper des Trägerelements. Der Temperatursensor wird somit über die Wärmeleiteinrichtung auch von unten erwärmt, sodass verhindert ist, dass von Seiten des Funktionselements in den Temperatursensor eingeleitete Wärme unmittelbar in das Trägerelement abfließen kann. Das Ansprechverhalten der Temperaturüberwachungseinrichtung kann auf diese Weise verbessert sein, sodass ein Temperaturanstieg an dem elektrischen Funktionselement über den Temperatursensor mit geringer zeitlicher Verzögerung detektiert werden kann.

Das Anlageelement und/oder die zumindest eine Wärmeleiteinrichtung können beispielsweise aus einem metallischen, gut wärmeleitfähigen Material gefertigt sein. Alternativ können das Anlageelement und/oder die zumindest eine Wärmeleiteinrichtung auch aus einem thermisch leitfähigen Kunststoffmaterial oder einem Keramikmaterial gefertigt sein.

Das Trägerelement ist beispielsweise durch eine Leiterplatte verwirklicht. Der Körper der Leiterplatte besteht hierbei aus einem elektrisch nicht leitfähigen Material, auf dem Leiterbahnen aufgebracht und/oder in den Leiterbahnen zum Beispiel in unterschiedlichen Ebenen eingebracht sind.

Die zumindest eine Durchkontaktierung erstreckt sich, in einer Ausgestaltung, ausgehend von dem Anlageelement an der Oberfläche des Trägerelements zumindest teilweise durch den Körper des Trägerelements hindurch. Unterhalb des Anlageelements gelegene Wärmeleiteinrichtungen sind somit über die zumindest eine Durchkontaktierung mit dem Anlageelement kontaktiert und damit thermisch mit dem Anlageelement gekoppelt.

Bei der zumindest einen Durchkontaktierung handelt es sich nach dem üblichen fachmännischen Verständnis um eine im Wesentlichen vertikal durch das Trägerelement hindurch erstreckte elektrische Verbindung, über die bei einem als Leiterplatte ausgebildeten Trägerelement zueinander versetzte Ebenen der Leiterplatte miteinander verbunden sein können. Die Durchkontaktierung kann eine an ihrer inneren Mantelfläche metallisierte Bohrung aufweisen, wobei vorzugsweise eine jede Durchkontaktierung mit einer thermisch leitfähigen Füllmasse, insbesondere einem Lötmaterial, gefüllt ist. Das Füllen der zumindest einen Durchkontaktierung kann beispielsweise unter Verwendung eines Reflow-Lötprozesses erfolgen, im Rahmen dessen Lötmasse in eine jede Durchkontaktierung der Temperaturüberwachungseinrichtung eingebracht wird.

In einer Ausgestaltung ist die zumindest eine Wärmeleiteinrichtung über mehrere Durchkontaktierungen, die entlang einer um den Temperatursensor herumweisenden Umfangsrichtung aneinander angereiht sind, thermisch mit dem Anlageelement verbunden. Die Durchkontaktierungen können beispielsweise entlang eines Kreisbogens oder eines geschlossenen Kreises aneinander angereiht sein und stellen somit an zueinander beabstandeten Orten eine Kopplung zwischen der zumindest einen Wärmeleiteinrichtung und dem Anlageelement her. Auf diese Weise kann Wärme von dem Anlageelement in gleichförmiger Weise in die zumindest eine Wärmeleiteinrichtung eingeleitet werden, sodass die zumindest eine Wärmeleiteinrichtung unterhalb des Temperatursensors in gleichförmiger Weise erwärmt wird.

In einer Ausgestaltung erstreckt sich das Anlageelement zumindest abschnittsweise an der Oberfläche des Trägerelements um den Temperatursensor herum. Das Anlageelement kann beispielsweise die Form eines umfänglich geschlossenen oder umfänglich an einer oder mehreren Stellen geöffneten Rings aufweisen. Das Anlageelement kann beispielsweise aber auch eine eckige Form, beispielsweise eine viereckige Form, aufweisen.

In einer Ausgestaltung weist das Anlageelement eine Aussparung auf, an der das Anlageelement, betrachtet entlang einer um den Temperatursensor herum weisenden Umfangsrichtung, unterbrochen ist. Durch eine solche Aussparung können sich beispielsweise Zuleitungen, die mit dem Temperatursensor verbunden sind, hindurcherstrecken. Die Zuleitungen verlaufen entlang der Oberfläche des Trägerelements und sind an den Temperatursensor angeschlossen, sind dabei aber nicht mit dem Anlageelement kontaktiert, sondern sind durch die Aussparung hindurch aus dem Anlageelement herausgeführt.

Die Zuleitungen sind vorzugsweise nicht in Anlage mit der Kopplungsfläche. Über die Kopplungsfläche wird somit, bei mehreren Zuleitungen, kein Kurzschluss zwischen benachbarten Zuleitungen hergestellt. Insbesondere kann hierzu an der Kopplungsfläche eine Ausnehmung geformt sein, in der die Zuleitungen einliegen, sodass eine Berührung zwischen der Kopplungsfläche und den Zuleitungen vermieden ist.

In einer Ausgestaltung weist die Temperaturüberwachungseinrichtung mehrere in dem Körper des Trägerelements eingebettete, parallel zueinander erstreckte Wärmeleiteinrichtungen auf. Eine Mehrzahl von Wärmeleiteinrichtungen ist somit in unterschiedlichen Ebenen in den Körper des Trägerelements eingebracht, wobei die Wärmeleiteinrichtungen beispielsweise jeweils eine Scheibenform, beispielsweise in Form einer Kreisscheibe, aufweisen können oder auch unterschiedlich geformt sein können. Die Wärmeleiteinrichtungen sind über eine oder mehrere Durchkontaktierungen jeweils thermisch mit dem Anlageelement gekoppelt, sodass Wärme über eine oder mehrere Durchkontaktierungen in sämtliche Wärmeleiteinrichtungen eingeleitet werden kann.

Erfindungsgemäß ist an der Kopplungsfläche eine Aufnahmekammer geformt, in der der Temperatursensor der Temperaturüberwachungseinrichtung aufgenommen ist. Die Kopplungsfläche ist somit in Anlage mit dem Anlageelement der Temperaturüberwachungseinrichtung und umgibt zudem den Temperatursensor, sodass der Temperatursensor durch die Kopplungsfläche eingehaust ist. Die Aufnahmekammer kann hierbei durch eine Wandung begrenzt sein, wobei vorzugsweise der Temperatursensor die Wandung nicht berührt. Der Temperatursensor ist somit mechanisch von der Kopplungsfläche unabhängig und wird im Betrieb nicht mit mechanischen Kräften durch die Kopplungsfläche beaufschlagt. Eine mechanische Belastung an dem Temperatursensor aufgrund der thermischen Kopplung mit dem elektrischen Funktionselement ist somit vermieden.

Wärme wird von oben über die Kopplungsfläche, in deren Aussparung der Temperatursensor aufgenommen ist, in den Temperatursensor eingeleitet. Zudem wird der Temperatursensor auch von unten - von Seiten des Trägerelements - erwärmt, indem Wärme von der zumindest einen in dem Körper des Trägerelements eingebetteten Wärmeleiteinrichtung hin zu dem Temperatursensor geleitet wird. Eine Kühlwirkung des Trägerelements wird hierdurch vermieden. Der Temperatursensor kann effizient aus seiner Umgebung Wärme aufnehmen und somit mit geringer zeitlicher Verzögerung auf eine Erwärmung an dem elektrischen Funktionselement ansprechen.

Der Temperatursensor ist in einer Ausgestaltung als oberflächenmontiertes Bauteil (sogenanntes SMD-Bauteil) ausgebildet und mit der Oberfläche des Trägerelements vorzugsweise über Lötverbindungen verbunden. Der Temperatursensor ist somit unmittelbar an der Oberfläche des Trägerelements angeordnet und mit dieser verbunden, wobei sich Zuleitungen von dem Temperatursensor erstrecken können, um Sensorsignale an eine übergeordnete elektrische Baugruppe, insbesondere eine Steuer- und Auswerteeinrichtung, abzugeben.

Erfindungsgemäß ist das elektrische Funktionselement mit einem Einsetzelement verbunden. Das Trägerelement weist eine Aufnahmeöffnung auf, in die das Einsetzelement eingesetzt ist, sodass über das Einsetzelement das elektrische Funktionselement an dem Trägerelement festgelegt werden kann. Das Einsetzelement kann beispielsweise eine Buchsenform mit einer Öffnung aufweisen, in die das elektrische Funktionselement eingesetzt ist. Das Einsetzelement kann beispielsweise aber auch einstückig mit dem elektrischen Funktionselement geformt sein.

In einer Ausgestaltung ist die Kopplungsfläche, über die die thermische Kopplung mit der Temperaturüberwachungseinrichtung hergestellt ist, an dem Einsetzelement geformt. Das Einsetzelement kann hierzu beispielsweise einen Flanschabschnitt aufweisen, der radial von dem elektrischen Funktionselement vorsteht und radial außerhalb einer Aufnahmeöffnung des Trägerelements, in die das elektrische Funktionselement eingesetzt ist, angeordnet ist. An dem Flanschabschnitt ist die Kopplungsfläche geformt, sodass über den Flanschabschnitt die thermische Kopplung mit der Temperaturüberwachungseinrichtung hergestellt wird.

Ist das Einsetzelement als gesondertes Element zu dem elektrischen Funktionselement ausgebildet, so kann das Einsetzelement aus einem elektrisch leitfähigen Metallmaterial, beispielsweise aus dem Material des elektrischen Funktionselements, ausgebildet sein. Alternativ kann das Einsetzelement aber auch aus einem nicht elektrisch leitfähigen, aber thermisch leitfähigen Material, zum Beispiel einem thermisch leitfähigen Kunststoffmaterial oder einem Keramikmaterial, geformt sein.

Der Flanschabschnitt kann insbesondere den Temperatursensor der Temperaturüberwachungseinrichtung überdecken. An einer dem Trägerelement zugewandten Seite des Flanschabschnitts ist die Kopplungsfläche geformt, wobei vorzugsweise an dieser Kopplungsfläche eine Aussparung geformt ist, in der der Temperatursensor aufgenommen ist, sodass der Temperatursensor durch den Flanschabschnitt überdeckt ist, ohne dabei aber notwendigerweise den Flanschabschnitt zu berühren.

Die elektrische Baugruppe kann beispielsweise Bestandteil eines Steckverbinderteils sein, das steckend mit einem zugeordneten Gegensteckverbinderteil verbunden werden kann.

Das elektrische Funktionselement kann in diesem Fall beispielsweise durch ein Kontaktelement, insbesondere einen Lastkontakt, des Steckverbinderteils verwirklicht sein, über den bei steckend mit dem Gegensteckverbinderteil verbundenem Steckverbinderteil eine elektrische Kontaktierung hergestellt ist und über den Lastströme geleitet werden.

An einem solchen Steckverbinderteil können auch mehrere Temperaturüberwachungseinrichtungen vorgesehen sein, wobei beispielsweise an jedem Kontaktelement, das zum Übertragen von Lastströmen dient, eine gesonderte Temperaturüberwachungseinrichtung vorgesehen sein kann. Die Temperaturüberwachungseinrichtungen können an einem gemeinsamen Trägerelement, zum Beispiel in Form einer Leiterplatte, angeordnet sein, wobei jede Temperaturüberwachungseinrichtung einen Temperatursensor, ein Anlageelement und zumindest eine in den Körper des Trägerelements eingebettete Wärmeleiteinrichtung aufweist.

Das Steckverbinderteil kann beispielsweise als Ladestecker oder als Ladebuchse eines Ladesystems zum Aufladen eines Elektrofahrzeugs Verwendung finden. Das Steckverbinderteil weist hierzu Kontaktelemente auf, die als Lastkontakte zum Übertragen eines Ladestroms zum Beispiel in Form eines Gleichstroms oder in Form eines Wechselstroms dienen. Eine Temperaturüberwachungseinrichtung ist vorzugsweise an solchen Lastkontakten angeordnet, wobei in einer vorteilhaften Ausgestaltung jedem Kontaktelement eine eigene Temperaturüberwachungseinrichtung zugeordnet ist. Die Temperaturüberwachungseinrichtung ist beispielsweise an eine Steuereinrichtung angeschlossen, sodass über die Temperaturüberwachungseinrichtung aufgenommene Signale ausgewertet und zum Steuern eines über die Lastkontakte übertragenen Ladestroms verwendet werden können.

Ein Temperatursensor der hier beschriebenen Art kann z.B. durch einen temperaturabhängigen Widerstand ausgebildet sein, beispielsweise einen Widerstand mit einem positiven Temperaturkoeffizienten (sogenannte PTC-Widerstände), dessen Widerstandswert mit steigender Temperatur ansteigt (auch bezeichnet als Kaltleiter, der bei niedriger Temperatur eine gute elektrische Leitfähigkeit und bei höheren Temperaturen eine reduzierte elektrische Leitfähigkeit aufweist). Solche Temperatursensoren können beispielsweise auch eine nichtlineare Temperaturkennlinie aufweisen und können beispielsweise aus einem Keramikmaterial hergestellt sein (sogenannte Keramik-Kaltleiter).

Es kann beispielsweise aber auch ein elektrischer Widerstand mit negativem Temperaturkoeffizienten (sogenannte NTC-Widerstände) als Temperatursensor zum Einsatz kommen, dessen Widerstandswert mit steigender Temperatur sinkt.

Alternativ oder zusätzlich können auch durch Halbleiterbauelemente ausgebildete Temperatursensoren zum Einsatz kommen.

Der der Erfindung zugrunde liegende Gedanke soll nachfolgend anhand der in den Figuren dargestellten Ausführungsbeispiele näher erläutert werden. Es zeigen:
- Fig. 1: eine schematische Darstellung eines Elektrofahrzeugs mit einem Ladekabel und einer Ladestation zum Aufladen;
- Fig. 2: eine Ansicht eines Steckverbinderteils in Form eines Inlets auf Seiten eines Fahrzeugs;
- Fig. 3: eine Ansicht eines Ausführungsbeispiels einer elektrischen Baugruppe, umfassend ein Trägerelement und an dem Trägerelement angeordnete elektrische Funktionselemente in Form von Kontaktelementen;
- Fig. 4: eine Ansicht der elektrischen Baugruppe, mit einem einzelnen an dem Trägerelement angeordneten elektrischen Funktionselement;
- Fig. 5: eine Explosionsansicht der Anordnung gemäß Fig. 4;
- Fig. 6: eine ausschnittsweise vergrößerte Ansicht der Anordnung gemäß Fig. 5;
- Fig. 7: eine Seitenansicht der Anordnung gemäß Fig. 4;
- Fig. 8: eine ausschnittsweise vergrößerte, geschnittene Ansicht der Anordnung gemäß Fig. 7;
- Fig. 9: eine Ansicht einer Temperaturüberwachungseinrichtung der elektrischen Baugruppe, ohne das Trägerelement;
- Fig. 10: eine Teilschnittansicht der Temperaturüberwachungseinrichtung an dem Trägerelement der elektrischen Baugruppe;
- Fig. 11: die Ansicht gemäß Fig. 10, ohne das Trägerelement;
- Fig. 12: eine vergrößerte Ansicht der Temperaturüberwachungseinrichtung im Bereich einer Durchkontaktierung; und
- Fig. 13: eine Ansicht von Durchkontaktierungen, vor Befüllung mit einer Füllmasse und nach Befüllung mit einer Füllmasse.

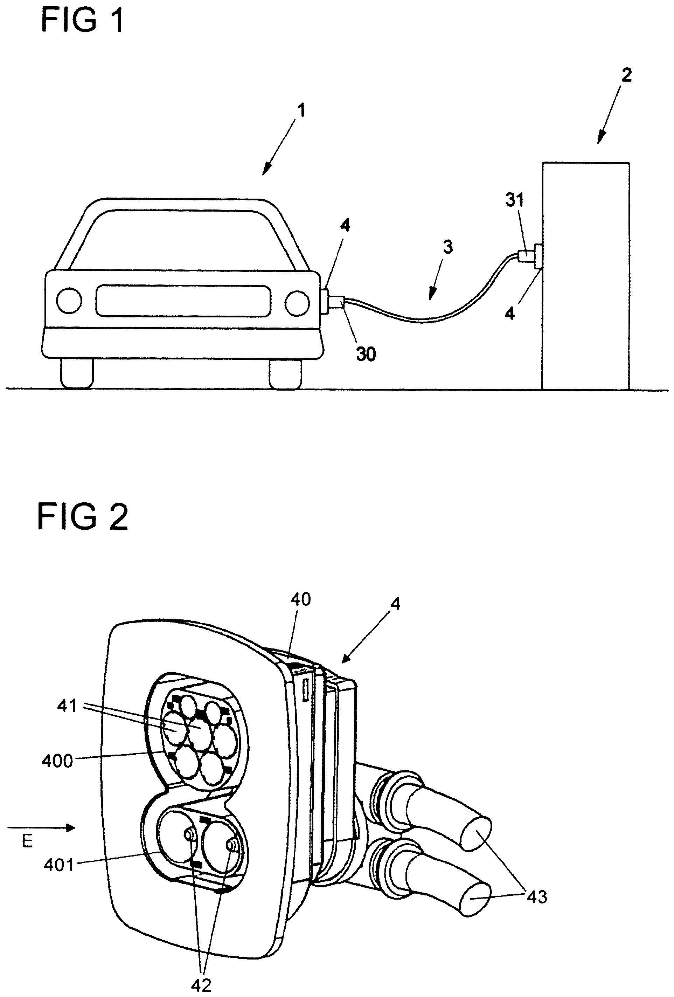

Fig. 1 zeigt in einer schematischen Ansicht ein Fahrzeug 1 in Form eines elektromotorisch angetriebenen Fahrzeugs (bezeichnet auch als Elektrofahrzeug). Das Elektrofahrzeug 1 verfügt über elektrisch aufladbare Batterien, über die ein Elektromotor zum Fortbewegen des Fahrzeugs 1 elektrisch versorgt werden kann.

Um die Batterien des Fahrzeugs 1 aufzuladen, kann das Fahrzeug 1 über ein Ladekabel 3 an eine Ladestation 2 angeschlossen werden. Das Ladekabel 3 kann hierzu mit einem Ladestecker 30 an einem Ende in ein zugeordnetes Gegensteckverbinderteil 4 in Form einer Ladebuchse des Fahrzeugs 1 eingesteckt werden und steht an seinem anderen Ende über einen anderen Ladestecker 31 mit einem Steckverbinderteil 4 in Form einer Ladebuchse an der Ladestation 2 in elektrischer Verbindung. Über das Ladekabel 3 werden Ladeströme mit vergleichsweise großer Stromstärke hin zum Fahrzeug 1 übertragen.

Das Steckverbinderteil 4 aufseiten des Fahrzeugs 1 und das Steckverbinderteil 4 aufseiten der Ladestation 2 können sich unterscheiden. Möglich ist auch, das Ladekabel 3 fest an der Ladestation 2 (ohne Steckverbinderteil 4) anzuordnen.

Fig. 2 zeigt ein Ausführungsbeispiel eines Steckverbinderteils 4 in Form einer Ladebuchse zum Beispiel auf Seiten eines Fahrzeugs (auch bezeichnet als Fahrzeuginlet), das steckend mit einem zugeordneten Gegensteckverbinderteil 30 in Form eines Ladesteckers an einem Ladekabel 3 verbunden werden kann, um das Elektrofahrzeug 1 mit der Ladestation 2 des Ladesystems zu verbinden. Das Steckverbinderteil 4 weist ein Gehäuseteil 40 auf, an dem Steckabschnitte 400, 401 geformt sind, mit denen das Steckverbinderteil 30 entlang einer Steckrichtung E steckend verbunden werden kann. An den Steckabschnitten 400, 401 sind Stecköffnungen gebildet, in denen Kontaktelemente 41, 42 angeordnet sind, über die bei steckendem Verbinden eine elektrische Verbindung zu dem zugeordneten Gegensteckverbinderteil 30 hergestellt werden kann.

Bei dem dargestellten Ausführungsbeispiel sind an einem ersten, oberen Steckabschnitt 400 Kontaktelemente 41 angeordnet, über die zum Beispiel ein Ladestrom in Form eines Wechselstroms übertragen werden kann. Zusätzlich können Kontaktelemente vorhanden sein, über die Steuersignale übertragen werden können.

An einem zweiten, unteren Steckabschnitt 401 sind demgegenüber zwei Kontaktelemente 42 angeordnet, über die ein Ladestrom in Form eines Gleichstroms übertragen werden kann. Die Kontaktelemente 42 sind mit Lastleitungen 43 verbunden, über die der Ladestrom geleitet wird.

Im Betrieb kommt es bei Übertragen eines Ladestroms zu einer Erwärmung an den Kontaktelementen 41, 42, wobei insbesondere über die Kontaktelemente 42 zum Übertragen eines Ladestroms in Form eines Gleichstroms Ströme großer Stromstärke fließen können, beispielsweise bis hin zu 500 A. Um eine übermäßige Erwärmung an dem Steckverbinderteil 4 auszuschließen und gegebenenfalls Maßnahmen einzuleiten, um einer übermäßigen Erwärmung entgegenzuwirken, ist ein Temperaturanstieg an den Kontaktelementen 42 zu überwachen.

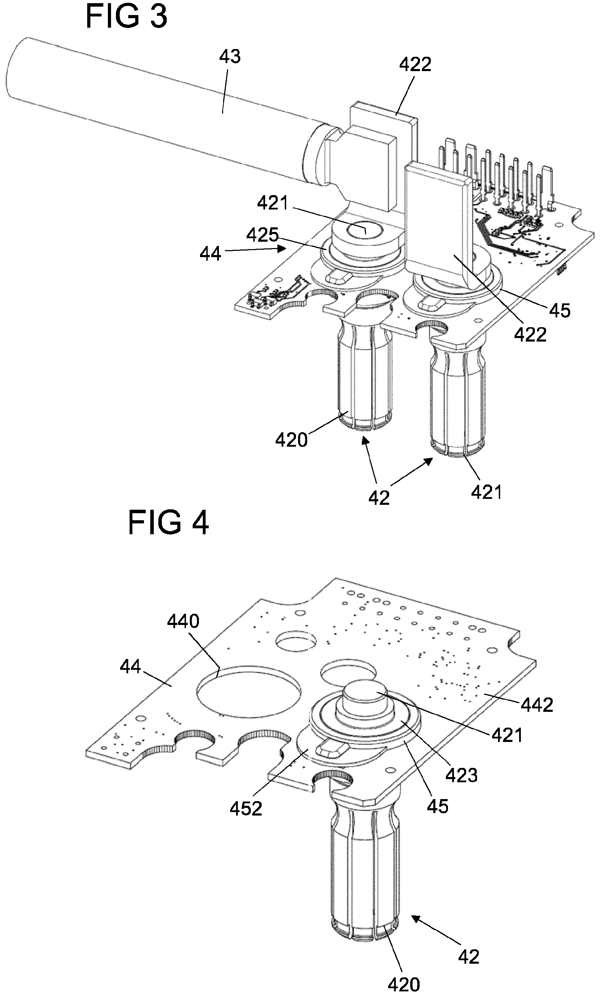

Um einen Temperaturanstieg an den als Lastkontakte dienenden Kontaktelementen 42 eines solchen Steckverbinderteils 4 zu überwachen, weist das Steckverbinderteil 4 eine elektrische Baugruppe auf, die in einem Ausführungsbeispiel in Fig. 3 bis 13 dargestellt ist.

In einer solchen elektrischen Baugruppe sind elektrische Funktionselemente in Form von Kontaktelementen 42 gemeinsam an einem Trägerelement 44 in Form einer Leiterplatte angeordnet und mit zugeordneten Lastleitungen 43 elektrisch verbunden. Ein jedes Kontaktelement 42 ist hierbei in einer zugeordneten Aufnahmeöffnung 440 des Trägerelements 44 aufgenommen und somit mit dem Trägerelement 44 wirkverbunden.

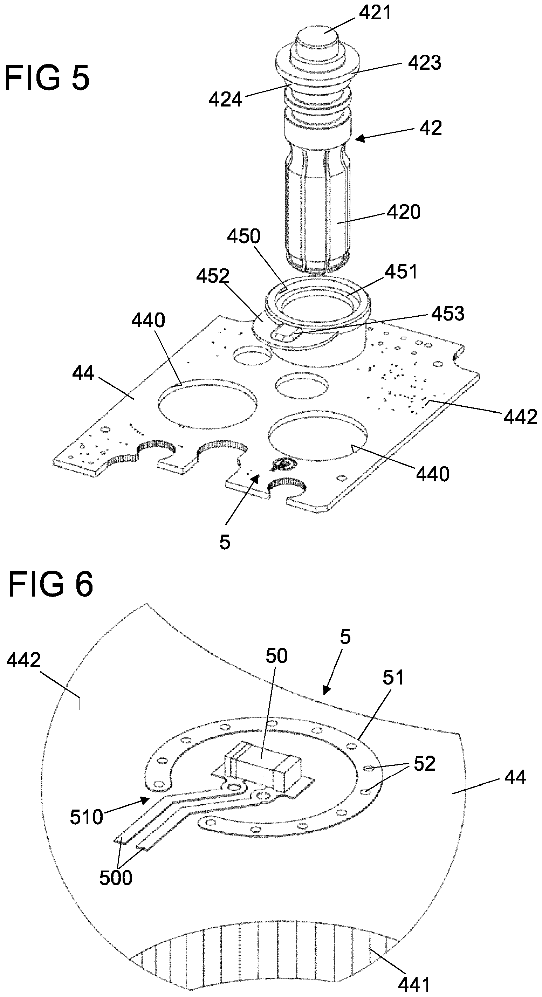

Ein jedes Kontaktelement 42 weist bei dem dargestellten Ausführungsbeispiel einen Buchsenabschnitt 420 zum steckenden Verbinden mit einem Gegenkontaktelement in Form eines Kontaktstifts auf, liegt mit einem Schaftabschnitt 424 in einer Öffnung 450 eines Einsetzelements 45 (siehe Fig. 5) ein und ist über das Einsetzelement 45 an dem Trägerelement 44 angeordnet. Ein Bund 423 des Kontaktelements 42 liegt hierbei an einem Ringbund 451 innerhalb der Öffnung 450 des zugeordneten Einsetzelements 45 ein und steht mit einem von dem Buchsenabschnitt 420 abgewandten Ende 421 von dem Trägerelement 44 vor. Über das Ende 421 ist das Kontaktelement 42 mit einem Anschlussabschnitt 422 und darüber mit einer zugeordneten Lastleitung 43 verbunden, wie dies aus Fig. 3 ersichtlich ist.

Ein jedes Kontaktelement 42 ist somit über ein zugeordnetes Einsetzelement 45 (indirekt) an dem Trägerelement 44 angeordnet. Das Einsetzelement 45 kann aus einem elektrisch leitfähigen Metallmaterial, beispielsweise dem gleichen Material wie das Kontaktelement 42, gefertigt sein. Alternativ kann das Einsetzelement 45 aber auch aus einem nicht elektrisch leitfähigen, aber thermisch leitfähigen Material, beispielsweise einem thermisch leitfähigen Kunststoffmaterial oder einem Keramikmaterial, gefertigt sein.

Das Einsetzelement 45 weist, bei dem dargestellten Ausführungsbeispiel, einen radial von dem Kontaktelement 42 vorstehenden Flanschabschnitt 452 auf, der einen Bereich des Trägerelements 44 außerhalb der zugeordneten Aufnahmeöffnung 440 überdeckt. An dem Flanschabschnitt 452 ist eine Auswölbung 453 mit einer darin befindlichen Aufnahmekammer 454 geformt, die dazu dient, eine Temperaturüberwachungseinrichtung 5, die an einer dem Flanschabschnitt 452 zugewandten Oberfläche 442 des Trägerelements 44 angeordnet ist, aufzunehmen derart, dass ein Temperatursensor 50 der Temperaturüberwachungseinrichtung 5 zwischen dem Trägerelement 44 und dem Flanschabschnitt 452 eingehaust ist.

Die Temperaturüberwachungseinrichtung 5 weist, wie aus der vergrößerten Ansicht gemäß Fig. 6 ersichtlich ist, einen Temperatursensor 50 auf, der als oberflächenmontiertes SMD-Bauteil ausgebildet und an der Oberfläche 442 des Trägerelements 44 über Lötverbindungen fixiert ist. Umfänglich um den Temperatursensor 44 herum erstreckt sich ein Anlageelement 51, das die Form eines geöffneten Rings aufweist und eine Aussparung 510 ausbildet, durch die hindurch sich mit dem Temperatursensor 50 verbundene Zuleitungen 500 erstrecken.

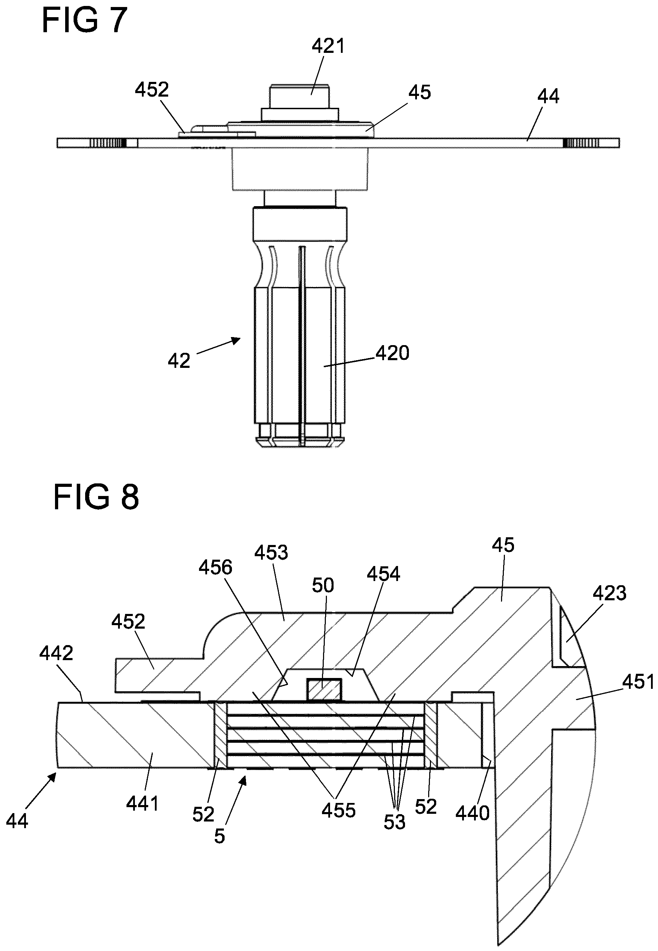

Das Anlageelement 51 ist, bei montiertem Kontaktelement 42, in Anlage mit einer an dem Flanschabschnitt 452 gebildeten Kopplungsfläche 455, wie dies insbesondere aus der vergrößerten Schnittansicht gemäß Fig. 8 ersichtlich ist. Über den Flanschabschnitt 452 und die kontaktierende Anlage der Kopplungsfläche 455 mit dem Anlageelement 51 ist das Einsetzelement 45 thermisch mit der Temperaturüberwachungseinrichtung 5 gekoppelt, sodass Wärme von dem Kontaktelement 42 über das Einsetzelement 45 in die Temperaturüberwachungseinrichtung 5 eingeleitet werden kann und eine Erwärmung an dem Kontaktelement 52 somit über die Temperaturüberwachungseinrichtung 5 detektiert werden kann.

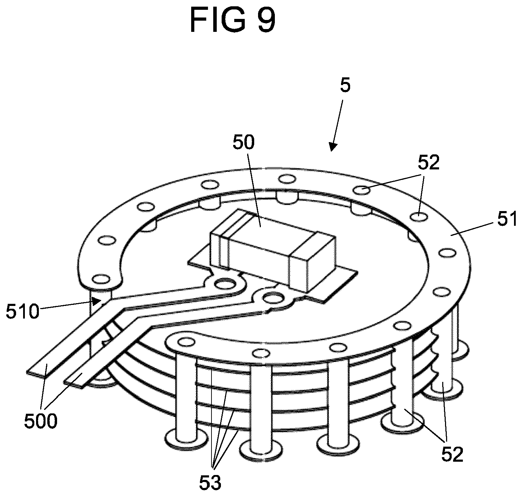

Wie aus der Schnittansicht gemäß Fig. 8 und zudem den gesonderten Ansichten der Temperaturüberwachungseinrichtung 5 gemäß Fig. 9 bis 11 ersichtlich ist, weist die Temperaturüberwachungseinrichtung 5 in einem Körper 441 des Trägerelements 44 eingebettete Wärmeleiteinrichtungen 53 auf, die jeweils scheibenförmig, insbesondere kreisscheibenförmig, ausgebildet sind und sich parallel zueinander entlang unterschiedlicher Ebenen in dem Körper 441 des Trägerelements 44 erstrecken. Die Wärmeleiteinrichtungen 53 erstrecken sich hierbei insbesondere unterhalb des Temperatursensors 50 in dem Trägerelement 44, sind dabei aber durch das (elektrisch nicht leitfähige) Material des Körpers 441 von dem Temperatursensor 50 getrennt und somit elektrisch zu dem Temperatursensor 50 isoliert.

Die Wärmeleiteinrichtungen 53 sind über eine Mehrzahl von Durchkontaktierungen 52 mit dem Anlageelement 51 verbunden, wie dies beispielsweise aus Fig. 9 bis 11 ersichtlich ist. Die Durchkontaktierungen 52 sind entlang einer um den Temperatursensor 50 herum weisenden Umfangsrichtung gleichbeabstandet an dem Anlageelement 51 aneinander angereiht.

Die Durchkontaktierungen 52 erstrecken sich ausgehend von dem Anlageelement 51 im Wesentlichen senkrecht durch den Körper 441 des Trägerelements 44 hindurch und sind mit den Wärmeleiteinrichtungen 53 verbunden, wie dies beispielsweise aus Fig. 9 ersichtlich ist, sodass Wärme von dem Anlageelement 51 über die Durchkontaktierungen 52 in die Wärmeleiteinrichtungen 53 eingeleitet und somit unterhalb des Temperatursensors 50 in dem Trägerelement 44 verteilt werden kann.

Weil der Temperatursensor 50 zum einen in der Aufnahmekammer 454 der Auswölbung 453 des Flanschabschnitts 452 aufgenommen und somit zwischen dem Flanschabschnitt 452 und dem Trägerelement 44 eingehaust ist und weil zum zweiten der Temperatursensor 50 über die sich unterhalb des Temperatursensors 50 in dem Trägerelement 44 erstreckenden Wärmeleiteinrichtungen 53 auch von unten, also vom Inneren des Trägerelements 44 her erwärmt wird, wird Wärme effizient in den Temperatursensor 50 eingeleitet, sodass der Temperatursensor 50 eine Erwärmung an dem zugeordneten Kontaktelement 52 ohne größere zeitliche Verzögerung aufnehmen kann. Aufgrund der Erwärmung durch die Wärmeleiteinrichtungen 53 von unten wird insbesondere vermieden, dass Wärme vom Temperatursensor 50 in das Trägerelement 44 abfließen kann und das Trägerelement 44 an dem Temperatursensor 50 somit eine Kühlwirkung ausübt, was zu einer Verzögerung des Ansprechverhaltens des Temperatursensors 50 führen könnte.

Weil die Umgebung des Temperatursensors 50 in gleichförmiger Weise über den Flanschabschnitt 452 und die Wärmeleiteinrichtungen 53 erwärmt wird und der Temperatursensor 50 Wärme somit gleichförmig aus seiner Umgebung aufnimmt, kann der Temperatursensor 50 mit schneller Reaktionszeit auf eine Erwärmung an dem Kontaktelement 42 ansprechen.

Wie aus Fig. 8 ersichtlich, liegt der Temperatursensor 50 hierbei mechanisch nicht an dem Flanschabschnitt 452 an. Insbesondere berührt der Temperatursensor 50 eine die Aufnahmekammer 454 begrenzende innere Wandlung 456 des Flanschabschnitts 452 nicht, sodass eine mechanische Belastung des Temperatursensors 50 über den Flanschabschnitt 452 vermieden ist.

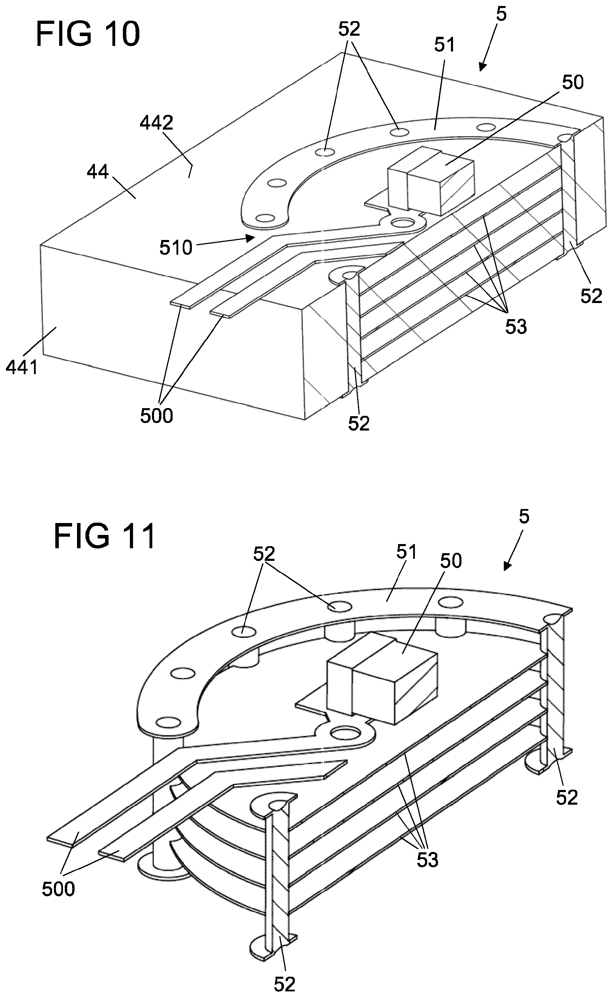

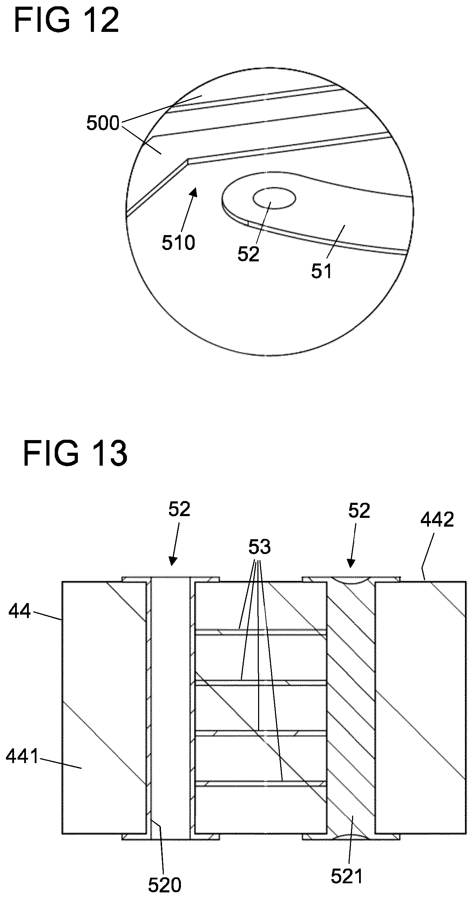

Die Durchkontaktierungen 52 erstrecken sich ausgehend von dem Anlageelement 51 bei dem dargestellten Ausführungsbeispiel vollständig durch den Körper 441 des Trägerelements 44 hindurch, wie dies beispielsweise aus Fig. 10 ersichtlich ist. Die Durchkontaktierungen 52 sind durch eine innenseitig metallisierte Bohrung gebildet, die eine Öffnung 520 ausbildet, wie dies in Fig. 13 links dargestellt ist. Für eine verbesserte Wärmeleitung ist die Öffnung 520 hierbei mit einer Füllmasse 521 in Form einer Lötmasse (Lötzinn) gefüllt, wie dies in Fig. 13 rechts dargestellt ist. Das Befüllen kann beispielsweise unter Verwendung eines Reflow-Lötprozesses bei Herstellung erfolgen.

Der Flanschabschnitt 452 kontaktiert die Zuleitungen 500 des Temperatursensors 50 nicht und stellt somit insbesondere keinen Kurzschluss zwischen den Zuleitungen 500 her. Um den Flanschabschnitt 452 von den Zuleitungen 500 elektrisch zu isolieren, kann an dem Flanschabschnitt 452 beispielsweise eine Ausnehmung geformt sein, in der die Zuleitungen 500 einliegen. Zusätzlich oder alternativ kann zwischen dem Flanschabschnitt 452 und den Zuleitungen 500 ein elektrisch isolierendes Element angeordnet sein.

Der Flanschabschnitt 452 liegt bei montierter Baugruppe an dem Anlageelement 51 der Temperaturüberwachungseinrichtung 5 an. Der Flanschabschnitt 452 kann hierbei über die Kopplungsfläche 455 direkt an dem Anlageelement 51 anliegen. Gegebenenfalls kann in einem Fügespalt zwischen der Kopplungsfläche 455 und dem Anlageelement 51 aber auch ein den Wärmeübergang verbesserndes Material (ein sogenannter Gapfiller) eingebracht sein.

Der der Erfindung zugrunde liegende Gedanke ist nicht auf die vorangehend geschilderten Ausführungsbeispiele beschränkt, sondern lässt sich grundsätzlich auch in gänzlich andersgearteter Weise verwirklichen.

Ein Steckverbinderteil der hier beschriebenen Art kann vorteilhaft in einem Ladesystem zum Aufladen eines Elektrofahrzeugs verwendet werden. Das Steckverbinderteil kann hierbei eine Ladebuchse (wie bei dem dargestellten Ausführungsbeispiel) oder auch einen Ladestecker verwirklichen.

Denkbar ist aber auch eine andere Verwendung. Grundsätzlich ist ein Steckverbinderteil der beschriebenen Art überall dort einsetzen, wo eine Temperaturüberwachung zum Beispiel an Kontaktelementen wünschenswert ist.

Das Anlageelement, über das das Kontaktelement thermisch mit der Temperaturüberwachungseinrichtung koppelt, kann als geöffneter Ring ausgebildet sein, wie bei dem dargestellten Ausführungsbeispiel. Denkbar und möglich ist aber auch, dass mehrere Anlageelement, zum Beispiel in Form von um den Temperatursensor verteilten Flächenabschnitten, zur Kopplung vorgesehen sind. Das Anlageelement kann zudem beispielsweise eckig, zum Beispiel viereckig ausgebildet sein.

### Bezugszeichenliste

- 1: Fahrzeug
- 2: Ladestation
- 3: Ladekabel
- 30, 31: Ladestecker
- 4: Steckverbinderteil
- 40: Gehäuseteil
- 400, 401: Steckabschnitt
- 41: Kontaktelement
- 42: Funktionselement (Kontaktelement)
- 420: Buchsenabschnitt
- 421: Ende
- 422: Anschlussabschnitt
- 423: Bund
- 424: Schaftabschnitt
- 43: Lastleitungen
- 44: Trägerelement (Leiterplatte)
- 440: Aufnahmeöffnung
- 441: Körper
- 442: Oberfläche
- 45: Einsetzelement
- 450: Öffnung
- 451: Ringbund
- 452: Flanschabschnitt
- 453: Auswölbung
- 454: Aufnahmekammer
- 455: Kopplungsfläche
- 456: Wandung
- 5: Temperaturüberwachungseinrichtung
- 50: Temperatursensor
- 500: Zuleitungen
- 51: Anlageelement
- 510: Aussparung
- 52: Durchkontaktierungen
- 520: Durchkontaktierungsöffnung
- 521: Füllmasse (Lötzinn)
- 53: Wärmeleiteinrichtungen
- E: Steckrichtung

## Patentansprüche

1. Elektrische Baugruppe, mit einem Trägerelement (44), das einen Körper (441) und eine an dem Körper (441) gebildete Oberfläche (442) aufweist, einem an dem Trägerelement (44) angeordneten, elektrischen Funktionselement (42) und einer an dem Trägerelement (44) angeordneten Temperaturüberwachungseinrichtung (5) zum Überwachen einer Temperatur an dem elektrischen Funktionselement (42), wobei die Temperaturüberwachungseinrichtung (5) einen an der Oberfläche (442) des Trägerelements (44) angeordneten Temperatursensor (50), ein an der Oberfläche (442) des Trägerelements (44) angeordnetes Anlageelement (51) und zumindest eine in dem Körper (441) des Trägerelements (44) eingebettete Wärmeleiteinrichtung (53) aufweist, wobei die zumindest eine Wärmeleiteinrichtung (53) sich zumindest abschnittsweise unterhalb des Temperatursensors (50) in dem Körper (441) erstreckt und thermisch über zumindest eine Durchkontaktierung (52) mit dem Anlageelement (51) verbunden ist und wobei das Anlageelement (51) in thermischer Kopplung mit einer mit dem elektrischen Funktionselement (42) wirkverbundenen Kopplungsfläche (455) ist, **dadurch gekennzeichnet, dass** das elektrische Funktionselement (42) mit einem Einsetzelement (45) verbunden ist und das Trägerelement (44) eine Aufnahmeöffnung (440) aufweist, in die das Einsetzelement (45) eingesetzt ist, wobei das Einsetzelement (45) einen Flanschabschnitt (452) aufweist, an dem die Kopplungsfläche (455) angeordnet ist, wobei an der Kopplungsfläche (455) eine Aufnahmekammer (454) geformt ist, in der der Temperatursensor (50) der Temperaturüberwachungseinrichtung (5) aufgenommen ist.

2. Elektrische Baugruppe nach Anspruch 1, **dadurch gekennzeichnet, dass** die zumindest eine Durchkontaktierung (52) ausgehend von der Oberfläche (442) durch den Körper (441) des Trägerelements (44) hindurch erstreckt ist.

3. Elektrische Baugruppe nach Anspruch 1 oder 2, **dadurch gekennzeichnet, dass** die zumindest eine Durchkontaktierung (52) mit einer thermisch leitfähigen Füllmasse (521) gefüllt ist.

4. Elektrische Baugruppe nach einem der Ansprüche 1 bis 3, **dadurch gekennzeichnet, dass** die zumindest eine Wärmeleiteinrichtung (53) über mehrere Durchkontaktierungen (52), die entlang einer um den Temperatursensor (50) herum weisenden Umfangsrichtung aneinander angereiht sind, thermisch mit dem Anlageelement (51) verbunden ist.

5. Elektrische Baugruppe nach einem der vorangehenden Ansprüche, **dadurch gekennzeichnet, dass** das Anlageelement (51) sich zumindest abschnittsweise an der Oberfläche (442) um den Temperatursensor (50) herum erstreckt.

6. Elektrische Baugruppe nach einem der vorangehenden Ansprüche, **dadurch gekennzeichnet, dass** das Anlageelement (51) eine Aussparung (510) aufweist, an der das Anlageelement (51), betrachtet entlang einer um den Temperatursensor (50) herum weisenden Umfangsrichtung, unterbrochen ist, wobei sich zumindest eine mit dem Temperatursensor (50) verbundene Zuleitung (500) an der Oberfläche (442) des Trägerelements (44) durch die Aussparung (510) hindurch erstreckt.

7. Elektrische Baugruppe nach einem der vorangehenden Ansprüche, **dadurch gekennzeichnet, dass** die Temperaturüberwachungseinrichtung (5) mehrere in dem Körper (441) des Trägerelements (44) eingebettete, parallel zueinander erstreckte Wärmeleiteinrichtungen (53) aufweist.

8. Elektrische Baugruppe nach einem der Ansprüche 1 bis 7, **dadurch gekennzeichnet, dass** der Temperatursensor (50) eine die Aufnahmekammer (454) begrenzende Wandung (456) nicht berührt.

9. Elektrische Baugruppe nach einem der vorangehenden Ansprüche, **dadurch gekennzeichnet, dass** der Temperatursensor (50) als SMD-Bauteil mit der Oberfläche (442) des Trägerelements (44) verbunden ist.

10. Elektrische Baugruppe nach einem der Ansprüche 1 bis 9, **dadurch gekennzeichnet, dass** das Einsetzelement (45) eine Öffnung (450) aufweist, in die das elektrische Funktionselement (42) eingesetzt ist.

11. Steckverbinderteil (4) zum steckenden Verbinden mit einem zugeordneten Gegensteckverbinderteil (30, 31), wobei das Steckverbinderteil (4) eine elektrische Baugruppe nach einem der vorangehenden Ansprüche aufweist und das elektrische Funktionselement (42) ein Kontaktelement zum elektrischen Kontaktieren mit dem Gegensteckverbinderteil (30, 31) ausbildet.

## Claims

1. Electrical assembly, comprising a support element (44) which has a body (441) and a surface (442) formed on the body (441), an electrical functional element (42) arranged on the support element (44), and a temperature-monitoring device (5), arranged on the support element (44), for monitoring a temperature at the electrical functional element (42), wherein the temperature-monitoring device (5) has a temperature sensor (50) arranged on the surface (442) of the support element (44), a bearing-contact element (51) arranged on the surface (442) of the support element (44), and at least one heat-conducting device (53) embedded in the body (441) of the support element (44), wherein the at least one heat-conducting device (53) extends at least in sections below the temperature sensor (50) in the body (441) and is thermally connected to the bearing-contact element (51) via at least one plated through-hole (52), and wherein the bearing-contact element (51) is thermally coupled to a coupling surface (455) operatively connected to the electrical functional element (42), **characterized in that** the electrical functional element (42) is connected to an insertion element (45) and the support element (44) has a receiving opening (440) into which the insertion element (45) is inserted, wherein the insertion element (45) has a flange portion (452) on which the coupling surface (455) is arranged, wherein a receiving chamber (454) is formed on the coupling surface (455), the temperature sensor (50) of the temperature-monitoring device (5) being received in the receiving chamber.

2. Electrical assembly according to Claim 1, **characterized in that** the at least one plated through-hole (52) extends through the body (441) of the support element (44) starting from the surface (442).

3. Electrical assembly according to Claim 1 or 2, **characterized in that** the at least one plated through-hole (52) is filled with a thermally conductive filling compound (521).

4. Electrical assembly according to any of Claims 1 to 3, **characterized in that** the at least one heat-conducting device (53) is thermally connected to the bearing-contact element (51) via a plurality of plated through-holes (52), which are lined up with each other along a circumferential direction around the temperature sensor (50).

5. Electrical assembly according to any of the preceding claims, **characterized in that** the bearing-contact element (51) extends at least in sections on the surface (442) around the temperature sensor (50).

6. Electrical assembly according to any of the preceding claims, **characterized in that** the bearing-contact element (51) has a cutout (510), at which the bearing-contact element (51) is interrupted as viewed along a circumferential direction around the temperature sensor (50), wherein at least one supply line (500) connected to the temperature sensor (50) extends through the cutout (510) on the surface (442) of the support element (44).

7. Electrical assembly according to any of the preceding claims, **characterized in that** the temperature-monitoring device (5) comprises a plurality of heat-conducting devices (53) embedded in the body (441) of the support element (44) and extending parallel to each other.

8. Electrical assembly according to any of Claims 1 to 7, **characterized in that** the temperature sensor (50) does not touch a wall (456) delimiting the receiving chamber (454).

9. Electrical assembly according to any of the preceding claims, **characterized in that** the temperature sensor (50) is connected as an SMD component to the surface (442) of the support element (44).

10. Electrical assembly according to any of Claims 1 to 9, **characterized in that** the insertion element (45) has an opening (450) into which the electrical functional element (42) is inserted.

11. Plug-in connector part (4) for plug-connection to an associated mating plug-in connector part (30, 31), wherein the plug-in connector part (4) has an electrical assembly according to any of the preceding claims and the electrical functional element (42) forms a contact element for electrical contact-connection to the mating plug-in connector part (30, 31).

## Revendications

1. Sous-ensemble électrique comprenant un élément porteur (44) qui possède un corps (441) et une surface (442) formée sur le corps (441), un élément fonctionnel électrique (42) disposé sur l'élément porteur (44) et un dispositif de surveillance de la température (5) disposé sur l'élément porteur (44), destiné à surveiller une température au niveau de l'élément fonctionnel électrique (42), le dispositif de surveillance de la température (5) comportant un capteur de température (50) disposé sur la surface (442) de l'élément porteur (44), un élément d'appui (51) disposé sur la surface (442) de l'élément porteur (44) et au moins un dispositif de conduction thermique (53) enrobé dans le corps (441) de l'élément porteur (44), ledit au moins un dispositif de conduction thermique (53) s'étendant au moins par sections sous le capteur de température (50) dans le corps (441) et étant relié thermiquement à l'élément d'appui (51) par le biais d'au moins un contact traversant (52), et l'élément d'appui (51) étant en couplage thermique avec une surface de couplage (455) reliée fonctionnellement à l'élément fonctionnel électrique (42), **caractérisé en ce que** l'élément fonctionnel électrique (42) est relié à un élément d'insertion (45), et l'élément porteur (44) présente une ouverture de réception (440) dans laquelle l'élément d'insertion (45) est inséré, l'élément d'insertion (45) présentant une partie formant bride (452) sur laquelle est disposée la surface de couplage (455), une chambre de réception (454), dans laquelle est reçu le capteur de température (50) du dispositif de surveillance de la température (5), étant formée sur la surface de couplage (455).

2. Sous-ensemble électrique selon la revendication 1, **caractérisé en ce que** ledit au moins un contact traversant (52) s'étend à travers le corps (441) de l'élément porteur (44) en partant de la surface (442).

3. Sous-ensemble électrique selon la revendication 1 ou 2, **caractérisé en ce qu'**au moins un contact traversant (52) est rempli d'une masse de remplissage thermiquement conductrice (521).

4. Sous-ensemble électrique selon l'une quelconque des revendications 1 à 3, **caractérisé en ce que** ledit au moins un dispositif de conduction thermique (53) est relié thermiquement à l'élément d'appui (51) par le biais de plusieurs contacts traversants (52), qui sont alignés les uns à la suite des autres le long d'une direction circonférentielle s'étendant autour du capteur de température (50).

5. Sous-ensemble électrique selon l'une quelconque des revendications précédentes, **caractérisé en ce que** l'élément d'appui (51) s'étend au moins par sections sur la surface (442) autour du capteur de température (50).

6. Sous-ensemble électrique selon l'une quelconque des revendications précédentes, **caractérisé en ce que** l'élément d'appui (51) présente un évidement (510) au niveau duquel l'élément d'appui (51) est interrompu, considéré le long d'une direction circonférentielle entourant le capteur de température (50), dans lequel au moins une ligne d'amenée (500) reliée au capteur de température (50) s'étend à travers l'évidement (510) sur la surface (442) de l'élément porteur (44).

7. Sous-ensemble électrique selon l'une quelconque des revendications précédentes, **caractérisé en ce que** le dispositif de surveillance de la température (5) comporte plusieurs dispositifs de conduction thermique (53) enrobés dans le corps (441) de l'élément porteur (44) et s'étendant parallèlement les uns aux autres.

8. Sous-ensemble électrique selon l'une quelconque des revendications 1 à 7, **caractérisé en ce que** le capteur de température (50) n'est pas en contact avec une paroi (456) délimitant la chambre de réception (454).

9. Sous-ensemble électrique selon l'une quelconque des revendications précédentes, **caractérisé en ce que** le capteur de température (50) est connecté en tant que composant SMD à la surface (442) de l'élément porteur (44).

10. Sous-ensemble électrique selon l'une quelconque des revendications 1 à 9, **caractérisé en ce que** l'élément d'insertion (45) présente une ouverture (450) dans laquelle l'élément de fonction électrique (42) est inséré.

11. Pièce de connecteur (4) destinée à la connexion par enfichage dans un contre-connecteur associé (30, 31), la pièce de connecteur (4) présentant un sous-ensemble électrique selon l'une quelconque des revendications précédentes et l'élément fonctionnel électrique (42) formant un élément de contact destiné à la mise en contact électrique avec le contre-connecteur (30, 31).
